# EUROPEAN PATENT APPLICATION

(11) **EP 4 517 832 A1**
(43) Date of publication of application: **05.03.2025**
(21) Application number: 23811033.2
(22) Date of filing: 23.05.2023
(51) Int. Cl.: H01L 29/778, H01L 29/02, H01L 29/12, H01L 29/15, H01L 29/20, H01L 29/06, H01L 29/36, H01L 21/335

(54) **SEMICONDUCTOR DEVICE, ELECTRONIC CHIP, AND ELECTRONIC DEVICE**

(30) Priority: 26.05.2022 CN 202210578786
(71) Applicant: Huawei Technologies Co., Ltd., Shenzhen, Guangdong 518129 (CN)
(72) Inventor: XUE, Pan, Shenzhen, Guangdong 518129 (CN); ZHENG, Dingheng, Shenzhen, Guangdong 518129 (CN); WEI, Wei, Shenzhen, Guangdong 518129 (CN); ZHANG, Yawen, Shenzhen, Guangdong 518129 (CN)
(74) Representative: Körber, Martin Hans
(86) International application number: PCT/CN2023/095704
(87) International publication number: WO 2023/226962

(57) **Abstract**

This application provides a semiconductor component, an electronic chip, and an electronic device, so that compressive stress and tensile stress of an epitaxial layer are balanced, to avoid cracking of the epitaxial layer, and a defect in the epitaxial layer is also reduced, to further improve reliability of the semiconductor component and prolong a service life of the semiconductor component. The semiconductor component may include a substrate, a first buffer layer, a second buffer layer, and a channel layer that are disposed in a stacked manner. The first buffer layer includes at least two first buffer sub-layers that are disposed in the stacked manner, and a second buffer sub-layer is disposed in the stacked manner between the at least two first buffer sub-layers. A first material is used for each of the at least two first buffer sub-layers, and a second material is used for the second buffer sub-layer. Elements included in the first material are not totally the same as elements included in the second material.

## Description

This application claims priority to Chinese Patent Application No. 202210578786.X, filed with the China National Intellectual Property Administration on May 26, 2022 and entitled "SEMICONDUCTOR COMPONENT, ELECTRONIC CHIP, AND ELECTRONIC DEVICE", which is incorporated herein by reference in its entirety.

### TECHNICAL FIELD

This application relates to the field of semiconductor technologies, and more specifically, to a semiconductor component, an electronic chip, and an electronic device.

### BACKGROUND

With the development of science and technologies, electronic chips including semiconductor components (such as field effect transistors) are widely used in electronic devices such as mobile phones and tablet computers. The semiconductor component may include a substrate, an epitaxial layer, and the like that are disposed in a stacked manner. A material of the substrate may be different from a material of the epitaxial layer, causing different lattice constants and thermal expansion coefficients of the substrate and the epitaxial layer. Therefore, compressive stress and tensile stress of the epitaxial layer need to be balanced, to avoid cracking of the epitaxial layer. In addition, a defect in the epitaxial layer reduces reliability of the semiconductor component, and shortens a service life of the semiconductor component.

Therefore, how to balance the compressive stress and the tensile stress of the epitaxial layer and reduce the defect in the epitaxial layer becomes a technical problem that needs to be urgently resolved.

### SUMMARY

This application provides a semiconductor component, an electronic chip, and an electronic device, so that compressive stress and tensile stress of an epitaxial layer are balanced, to avoid cracking of the epitaxial layer, and a defect in the epitaxial layer is also reduced, to further improve reliability of the semiconductor component and prolong a service life of the semiconductor component.

According to a first aspect, this application provides a semiconductor component, where the semiconductor component may include a substrate, a first buffer layer, a second buffer layer, and a channel layer that are disposed in a stacked manner.

The first buffer layer includes at least two first buffer sub-layers disposed in the stacked manner. A second buffer sub-layer may be disposed in the stacked manner between the at least two first buffer sub-layers.

Further, a first material may be used for each of the at least two first buffer sub-layers. A second material may be used for the second buffer sub-layer.

Elements included in the first material may be not totally the same as elements included in the second material. In other words, the elements included in the first material may be partially the same as or may be totally different from the elements included in the second material.

In this application, the elements included in the first material used for the first buffer sub-layer are not totally the same as the elements included in the second material used for the second buffer sub-layer, so that lattice constants of the first buffer sub-layer and the second buffer sub-layer are different. In this way, there is compressive stress between the first buffer sub-layer and the second buffer sub-layer. In addition, there is tensile stress between the substrate and the first buffer layer including the first buffer sub-layer and the second buffer sub-layer. Therefore, the compressive stress and the tensile stress can be mutually canceled out, to balance the compressive stress and the tensile stress of an epitaxial layer, and avoid cracking of the epitaxial layer. This is applicable to a semiconductor component that has a requirement on a thickness of the epitaxial layer (for example, the thickness of the epitaxial layer is greater than 5 µm).

In addition, in this application, the first buffer layer and the second buffer layer are used, so that lattice mismatch between the first buffer layer and the second buffer layer can be reduced, and lattice mismatch between the first buffer layer and the substrate can be further reduced, to reduce a defect in the epitaxial layer, such as dislocation, reduce off-state electric leakage of the semiconductor component, improve a subthreshold characteristic of the semiconductor component, increase an on-off ratio, a breakdown voltage, and the like of the semiconductor component, improve reliability of the semiconductor component, and prolong a service life of semiconductor components.

In a possible implementation, thicknesses of the at least two first buffer sub-layers may be the same. It may be understood that, that the thicknesses of the at least two first buffer sub-layers are the same does not mean that the thicknesses of the at least two first buffer sub-layers are the same in a mathematical strict sense, but a processing error is allowed in the thicknesses of the at least two first buffer sub-layers.

In another possible implementation, thicknesses of the at least two first buffer sub-layers increase or decrease progressively in a direction from the substrate to the channel layer. In other words, the thicknesses of the at least two first buffer sub-layers may be different in the direction from the substrate to the channel layer.

In still another possible implementation, a thickness of the second buffer sub-layer may be less than or equal to a thickness of each of the at least two first buffer sub-layers, so that lattice mismatch between the second buffer sub-layer and the first buffer sub-layer can be reduced, and the defect in the epitaxial layer, such as the dislocation, can be further reduced.

In some embodiments, the first material may be aluminum gallium nitride AlGaN (aluminum gallium nitride). AlGaN may represent an abbreviation of aluminum gallium nitride, and indicates elements included in aluminum gallium nitride. Alternatively, the first material may be indium aluminum nitride InAlN (indium aluminum nitride). InAlN may represent an abbreviation of indium aluminum nitride, and indicates elements included in indium aluminum nitride. The second material may be aluminum nitride AlN (aluminum nitride). AlN may represent an abbreviation of aluminum nitride, and indicates elements included in aluminum nitride. Certainly, the first material and the second material may alternatively be other materials. This is not limited in this application.

It may be figured out that the first material is AlGaN or InAlN, and the second material is AlN, so that the lattice mismatch between the first buffer sub-layer and the second buffer sub-layer can be reduced, and a defect in the first buffer layer, such as dislocation, can be further reduced.

In some other embodiments, components (indicating proportions of Al in first materials) of aluminum Al (Aluminum) in first materials respectively used for the at least two first buffer sub-layers may decrease progressively in the direction from the substrate to the channel layer, so that the lattice mismatch between the first buffer sub-layer and the second buffer sub-layer can be reduced, and the lattice mismatch between the first buffer layer and the substrate and the lattice mismatch between the first buffer layer and the second buffer layer can be further reduced.

Further, components of Al in first materials used for all the at least two first buffer sub-layers may be the same or decrease progressively in the direction from the substrate to the channel layer, so that a defect in each first buffer sub-layer, such as dislocation, can be reduced.

In a possible implementation, the first buffer layer may include three first buffer sub-layers.

A component of Al in AlGaN used for a first buffer sub-layer close to the substrate is greater than 0.6 and less than or equal to 0.9.

A component of Al in AlGaN used for a first buffer sub-layer close to the second buffer layer is greater than or equal to 0.1 and less than or equal to 0.3.

A component of Al in AlGaN used for a first buffer sub-layer between the first buffer sub-layer close to the substrate and the first buffer sub-layer close to the second buffer layer is greater than 0.3 and less than or equal to 0.6.

It can be learned that, components of Al in AlGaN respectively used for the three first buffer sub-layers may decrease in the direction from the substrate to the channel layer, so that the lattice mismatch between the first buffer sub-layer and the second buffer sub-layer can be reduced, and the lattice mismatch between the first buffer layer and the substrate and the lattice mismatch between the first buffer layer and the second buffer layer can be further reduced.

In another possible implementation, the first buffer layer may include three first buffer sub-layers.

A component of Al in InAlN used for a first buffer sub-layer close to the substrate is greater than 0.941 and less than or equal to 1.

A component of Al in InAlN used for a first buffer sub-layer close to the second buffer layer is greater than or equal to 0.825 and less than or equal to 0.883.

A component of Al in InAlN used for a first buffer sub-layer between the first buffer sub-layer close to the substrate and the first buffer sub-layer close to the second buffer layer is greater than 0.883 and less than or equal to 0.941.

It can be learned that, components of Al in InAlN respectively used for the three first buffer sub-layers may decrease in the direction from the substrate to the channel layer, so that the lattice mismatch between the first buffer sub-layer and the second buffer sub-layer can be reduced, and the lattice mismatch between the first buffer layer and the substrate and the lattice mismatch between the first buffer layer and the second buffer layer can be further reduced.

Further, a third buffer sub-layer may be further disposed in the stacked manner between the at least two first buffer sub-layers.

Further, a third material may be used for each of the third buffer sub-layer, the second buffer layer, and the channel layer. In other words, GaN is used for each of the third buffer sub-layer, the second buffer sub-layer, and the channel layer.

Elements included in the third material are not totally the same as the elements included in the first material and the elements included in the second material. In other words, the elements included in the third material may be partially the same as or may be totally different from the elements included in the first material and the elements included in the second material.

In some embodiments, the third material is gallium nitride GaN (GaN may represent an abbreviation of gallium nitride, and indicates elements included in gallium nitride). Certainly, the third material may alternatively be another material. This is not limited in this application.

In a possible implementation, a second buffer sub-layer may be disposed in the stacked manner between the first buffer sub-layer close to the substrate in the at least two first buffer sub-layers and the substrate.

In another possible implementation, a second buffer sub-layer is disposed in the stacked manner between the first buffer sub-layer close to the second buffer layer in the at least two first buffer sub-layers and the second buffer layer.

For example, the thickness of each first buffer sub-layer ranges from 5 nm to 300 nm. The thickness of the second buffer sub-layer ranges from 5 nm to 50 nm. A thickness of the first buffer layer is less than or equal to 1200 nm. A thickness of the second buffer layer ranges from 500 nm to 2000 nm. A thickness of the channel layer ranges from 50 nm to 1000 nm. A thickness of the third buffer sub-layer may range from 5 nm to 300 nm. Certainly, the first buffer sub-layer, the second buffer sub-layer, the first buffer layer, and the second buffer layer may alternatively be in other thickness ranges. This is not limited in this application.

In this application, the first buffer sub-layer and the second buffer sub-layer enable existence of compressive stress between the first buffer sub-layer and the second buffer sub-layer. Thickness selection of the first buffer layer and the second buffer layer enables existence of compressive stress between the first buffer layer and the second buffer layer, and can reduce the defect in the epitaxial layer, such as the dislocation. The third buffer sub-layer can be used to reduce lattice mismatch between the second buffer sub-layer and the second buffer sub-layer.

In a possible implementation, the semiconductor component provided in this application may further include a nucleation layer. The nucleation layer may be disposed in the stacked manner between the substrate and the first buffer layer. The nucleation layer is configured to provide a same nucleation center as the substrate, release mismatch stress generated by the lattice mismatch between the substrate and the first buffer layer and thermal stress generated by thermal expansion coefficient mismatch between the substrate and the first buffer layer, and provide a flatter surface for further growth of the first buffer layer.

The second material is used for the nucleation layer. In other words, AlN may be used for the nucleation layer. A thickness of the nucleation layer may range from 100 nm to 400 nm. Certainly, another material may alternatively be used for the nucleation layer, and the nucleation layer may alternatively be in another thickness range. This is not limited in this embodiment of this application.

In another possible implementation, a third buffer layer may be further disposed in the stacked manner between the second buffer layer and the channel layer.

Further, the first material may be used for the third buffer layer. In other words, AlGaN or InAlN may be used for the third buffer layer. A thickness of the third buffer layer ranges from 10 nm to 1000 nm. Certainly, another material may alternatively be used for the third buffer layer, and the third buffer layer may alternatively be in another thickness range. This is not limited in this embodiment of this application.

It may be figured out that the third buffer layer may be configured to isolate the channel layer from the second buffer layer, to improve confinement of two-dimensional electron gas. The channel layer and the third buffer layer form a heterojunction to provide a flow channel for the two-dimensional electron gas.

For example, the semiconductor component provided in this application may be a transistor or the like.

Further, the transistor may be a metal semiconductor field effect transistor (metal semiconductor field effect transistor, MESFET), a high electron mobility transistor (high electron mobility transistor, HEMT), a heterojunction field effect transistor (heterojunction field effect transistor, HFET), a light emitting diode (light emitting diode, LED), or the like.

According to a second aspect, this application provides an electronic chip, where the electronic chip may include a passive device and the semiconductor component provided in the first aspect and the possible implementations of the first aspect that is electrically connected to the passive device.

The passive device may include a resistor, a capacitor, and the like.

For example, the electronic chip may be a power amplification chip (with a power amplification function), a power supply chip (for example, with a direct current-direct current conversion function), or the like.

According to a third aspect, this application provides an electronic device, where the electronic device may include a circuit board and the electronic chip provided in the second aspect and the possible implementations of the second aspect.

In some other embodiments, the electronic device may be a mobile phone, a tablet computer, or the like.

It should be understood that technical solutions of the second aspect and the third aspect of this application are consistent with the technical solution of the first aspect of this application, and beneficial effects obtained by the aspects and corresponding feasible implementations are similar. Details are not described herein again.

### BRIEF DESCRIPTION OF DRAWINGS

To describe the technical solutions in this application or in the conventional technology more clearly, the following briefly describes the accompanying drawings used for describing embodiments or the conventional technology. It is clear that, the accompanying drawings in the following descriptions show some embodiments of this application, and a person of ordinary skill in the art may still derive other accompanying drawings from these accompanying drawings without creative efforts.
FIG. 1 is a diagram of a structure of a field effect transistor 10 according to an embodiment of this application;
FIG. 2 is a diagram of a structure of a field effect transistor 10 according to an embodiment of this application;
FIG. 3 is a diagram of a structure of a field effect transistor 10 according to an embodiment of this application;
FIG. 4 is a diagram of a flow rate setting manner of an MO gas source according to an embodiment of this application;
FIG. 5 is a diagram of a flow rate setting manner of an MO gas source according to an embodiment of this application;
FIG. 6 is a diagram of a flow rate setting manner of an MO gas source according to an embodiment of this application;
FIG. 7 is a diagram of a flow rate setting manner of an MO gas source according to an embodiment of this application;
FIG. 8 is a diagram of a flow rate setting manner of an MO gas source according to an embodiment of this application;
FIG. 9 is a diagram of a flow rate setting manner of an MO gas source according to an embodiment of this application;
FIG. 10 is a diagram of a structure of a field effect transistor 10 according to an embodiment of this application;
FIG. 11 is a diagram of a flow rate setting manner of an MO gas source according to an embodiment of this application;
FIG. 12 is a diagram of a flow rate setting manner of an MO gas source according to an embodiment of this application;
FIG. 13 is a diagram of a structure of a field effect transistor 10 according to an embodiment of this application;
FIG. 14 is a diagram of a structure of a field effect transistor 10 according to an embodiment of this application;
FIG. 15 is a diagram of a structure of a field effect transistor 10 according to an embodiment of this application; and
FIG. 16 is a diagram of a structure of a field effect transistor 10 according to an embodiment of this application.

### DESCRIPTION OF EMBODIMENTS

The following describes technical solutions of this application with reference to the accompanying drawings.

To make objectives, technical solutions, and advantages of this application clearer, the following clearly and completely describes the technical solutions in this application with reference to the accompanying drawings in this application. It is clear that the described embodiments are merely some rather than all of embodiments of this application. All other embodiments obtained by a person of ordinary skill in the art based on embodiments of this application without creative efforts shall fall within the protection scope of this application.

In the specification, embodiments, claims, and accompanying drawings of this application, the terms "first", "second", and the like are merely intended for distinguishing and description, and shall not be understood as indicating or implying relative importance, or indicating or implying a sequence. In addition, the terms "include", "have", and any variant thereof are intended to cover non-exclusive inclusion, for example, include a series of steps or units. A method, system, product, or device is not necessarily limited to those steps or units expressly listed, but may include other steps or units not expressly listed or inherent to such a process, method, product, or device.

It should be understood that in this application, "at least one" means one or more, and "a plurality of" means two or more. The term "and/or" is used to describe an association relationship between associated objects and represents that three relationships may exist. For example, "A and/or B" may represent the following three cases: Only A exists, only B exists, and both A and B exist, where A and B may be singular or plural. The character "/" generally indicates an "or" relationship between the associated objects. "At least one of the following items (pieces)" or a similar expression thereof refers to any combination of these items, including any combination of singular items (pieces) or plural items (pieces). For example, at least one of a, b, or c may indicate a, b, c, "a and b", "a and c", "b and c", or "a, b, and c", where a, b, and c may be singular or plural.

With the development of science and technologies, electronic chips including semiconductor components (for example, a field effect transistor, which may be a MESFET, an HEMT, an HFET, or the like) are widely used in electronic devices such as mobile phones and tablet computers. The field effect transistor may include a substrate and an epitaxial layer that are disposed in a stacked manner. A material of the substrate is different from a material of the epitaxial layer, causing different lattice constants and thermal expansion coefficients of the substrate and the epitaxial layer. Therefore, compressive stress and tensile stress of the epitaxial layer need to be balanced, to avoid cracking of the epitaxial layer. In addition, a defect in the epitaxial layer reduces reliability of the field effect transistor, and shortens a service life of the field effect transistor.

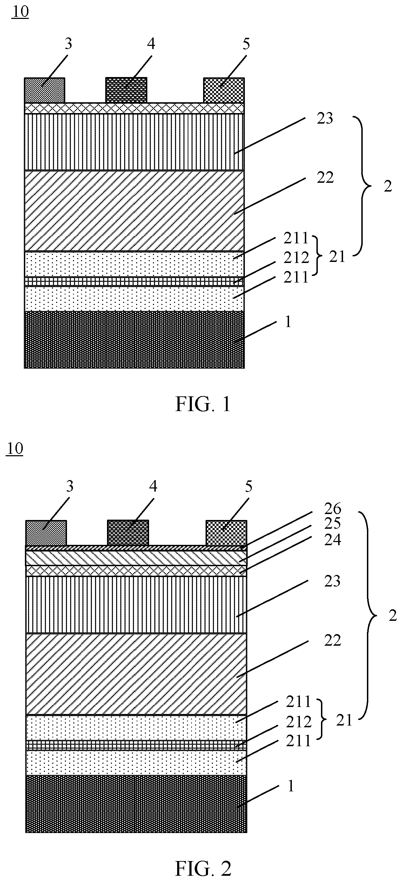

To overcome the foregoing defect, an embodiment of this application provides a field effect transistor 10, as shown in FIG. 1. The field effect transistor 10 may include a substrate 1, an epitaxial layer 2, a source electrode 3, a gate electrode 4, and a drain electrode 5.

The epitaxial layer 2 may be disposed on an upper surface of the substrate 1 in a stacked manner. The substrate 1 plays a role of supporting the epitaxial layer 2, and provides a growth direction or orientation for the epitaxial layer 2. The source electrode 3, the gate electrode 4, and the drain electrode 5 may be separately disposed on an upper surface of the epitaxial layer 2 in the stacked manner.

In a possible implementation, still with reference to FIG. 1, the epitaxial layer 2 may include a buffer layer 21 (that is, a first buffer layer), a buffer layer 22 (that is, a second buffer layer), and a channel layer 23 that are disposed on the substrate 1 in the stacked manner.

Further, the buffer layer 21 may include at least two (that is, two or more layers, where two layers are used as an example in FIG. 1) buffer sub-layers 211 (that is, first buffer sub-layers) that are disposed in the stacked manner. A buffer sub-layer 212 (that is, a second buffer sub-layer) may be disposed in the stacked manner between the at least two first buffer sub-layers.

In an example, a first material may be used for each of the at least two first buffer sub-layers. In other words, a same material may be used for the at least two first buffer sub-layers, and the first material may be used.

In another example, a second material may be used for the second buffer sub-layer.

Further, elements included in the first material may be not totally the same as elements included in the second material. In other words, the elements included in the first material may be partially different from or may be totally different from the elements included in the second material.

In this embodiment of this application, the elements included in the first material used for the buffer sub-layer 211 are not totally the same as the elements included in the second material used for the buffer sub-layer 212, so that lattice constants of the buffer sub-layer 211 and the buffer sub-layer 212 are different. In this way, there is compressive stress between the buffer sub-layer 211 and the buffer sub-layer 212. In addition, there is tensile stress between the substrate 1 and the buffer layer 21 including the buffer sub-layer 211 and the buffer sub-layer 212. Therefore, the compressive stress and the tensile stress can be mutually canceled out, to balance the compressive stress and the tensile stress of the epitaxial layer 2, and avoid cracking of the epitaxial layer 2. This is applicable to the field effect transistor 10 that has a requirement on a thickness of the epitaxial layer 2 (for example, the thickness of the epitaxial layer 2 may be greater than 5 µm).

Further, in this embodiment of this application, the buffer layer 21 and the buffer layer 22 are used, so that lattice mismatch between the buffer layer 21 and the buffer layer 22 can be reduced, and lattice mismatch between the buffer layer 21 and the substrate 1 can be further reduced, to reduce a defect in the epitaxial layer 2, such as dislocation, reduce off-state electric leakage of the field effect transistor 10, improve a subthreshold characteristic of the field effect transistor 10, increase an on-off ratio, a breakdown voltage, and the like of the field effect transistor 10, improve reliability of the field effect transistor 10, and prolong a service life of the field effect transistor 10.

In a possible implementation, a thickness of each buffer sub-layer 211 may range from 5 nm to 300 nm, a thickness of the buffer sub-layer 212 may range from 5 nm to 50 nm, a thickness of the buffer layer 21 may be less than or equal to 1200 nm, and a thickness of the buffer layer 22 ranges from 500 nm to 2000 nm. In this embodiment of this application, thickness selection of the buffer sub-layer 211 and the buffer sub-layer 212 enables existence of compressive stress between the buffer sub-layer 211 and the buffer sub-layer 212, and thickness selection of the buffer layer 21 and the buffer layer 22 enables existence of compressive stress between the buffer layer 21 and the buffer layer 22, and can reduce the defect in the epitaxial layer 2, such as the dislocation. Certainly, the buffer sub-layer 211, the buffer sub-layer 212, the buffer layer 21, and the buffer layer 22 may alternatively be in other thickness ranges. This is not limited in this embodiment of this application.

In a possible implementation, the epitaxial layer 2 may further include an insertion layer 24, a barrier layer 25, and a cap layer 26 that are disposed on an upper surface of the channel layer 23 in the stacked manner, as shown in FIG. 2.

In an example, any one of materials such as silicon Si (silicon) (which may be doped silicon or nondoped silicon), silicon carbide SiC (silicon carbide), aluminum oxide Al₂O₃ (aluminum oxide), diamond (diamond), gallium nitride GaN (gallium nitride), and gallium arsenide GaAs (gallium arsenide) may be used for the substrate 1. Certainly, the substrate 1 may alternatively be made of another material. This is not limited in this embodiment of this application.

In another example, a thickness of the channel layer 23 may range from 50 nm to 1000 nm, and gallium nitride GaN may be used for the channel layer 23. In this embodiment of this application, the channel layer 23 may increase concentration of two-dimensional electron gas generated by the channel layer 23, increase current density of the field effect transistor 10, and further increase an output current of the field effect transistor 10. Certainly, the channel layer 23 may alternatively be of another thickness, and another material may be alternatively used for the channel layer 23. This is not limited in this embodiment of this application.

In still another example, a thickness of the insertion layer 24 may range from 1 nm to 5 nm, and aluminum nitride AlN (aluminum nitride) may be used for the insertion layer 24. The insertion layer 24 may be configured to isolate the channel layer 23 from the barrier layer 25, and improve an interface between the channel layer 23 and the barrier layer 25. A thickness of the barrier layer 25 may range from 1 nm to 100 nm, and aluminum gallium nitride AlGaN (aluminum gallium nitride) may be used for the barrier layer 25. The barrier layer 25 and the channel layer 23 may form a heterojunction. A thickness of the cap layer 26 may range from 1 nm to 10 nm, and GaN may be used for the cap layer 26. The cap layer 26 may be configured to isolate the barrier layer 25 from the source electrode 3, the gate electrode 4, and the drain electrode 5, and protect an interface of the barrier layer 25. Certainly, the insertion layer 24, the barrier layer 25, and the cap layer 26 may alternatively be in other thickness ranges, or other materials may be used. This is not limited in this embodiment of this application.

In still another example, titanium Ti (titanium), aluminum Al (Aluminum), or a metal including a silicon component may be used for each of the source electrode 3 and the drain electrode 5. Alternatively, an alloy of at least two metals of titanium, aluminum, and a metal including a silicon component may be used for each of the source electrode 3 and the drain electrode 5. A metal such as nickel Ni (nickel), aurum Au (Aurum), or titanium or an alloy of at least two metals of nickel, aurum, and titanium may be used for the gate electrode 4. Certainly, another material may be used for each of the source electrode 3, the gate electrode 4, and the drain electrode 5. This is not limited in this embodiment of this application.

In still another example, the first material may be AlGaN or indium aluminum nitride InAlN (indium aluminum nitride), and the second material may be AlN, so that the lattice mismatch between the buffer sub-layer 211 and the buffer sub-layer 212 can be reduced, and a defect in the buffer layer 21, such as dislocation, can be further reduced. Certainly, the first material and the second material may alternatively be other materials. This is not limited in this embodiment of this application.

In some embodiments, thicknesses of the at least two buffer sub-layers 211 may be the same. It may be understood that, that thicknesses are the same does not mean that thickness values are the same in a mathematical strict sense, but a processing error is allowed in thicknesses, for example, an error is within 1% or within 2%.

In some embodiments, thicknesses of the at least two buffer sub-layers 211 are different in a direction from the substrate 1 to the channel layer 23. In some embodiments, thicknesses of the at least two buffer sub-layers 211 increase or decrease progressively in the direction from the substrate 1 to the channel layer 23.

It should be noted that, in this embodiment of this application, an example in which the thicknesses of the at least two buffer sub-layers 211 are the same is used for description.

In a possible implementation, components (indicating proportions of Al in first materials) of Al in first materials respectively used for the at least two buffer sub-layers 211 decrease progressively in the direction from the substrate 1 to the channel layer 23, so that the lattice mismatch between the buffer sub-layer 211 and the buffer sub-layer 212 can be reduced, and the lattice mismatch between the buffer layer 21 and the substrate 1 and the lattice mismatch between the buffer layer 21 and the buffer layer 22 can be further reduced.

In an implementation of the embodiments shown in FIG. 1 and FIG. 2, for example, a component of Al in AlGaN used for the buffer sub-layer 211 close to the buffer layer 22 may be less than a component of Al in AlGaN used for the buffer sub-layer 211 close to the substrate 1. In an implementation of the embodiments shown in FIG. 1 and FIG. 2, for another example, when the direction from the substrate 1 to the channel layer 23 is a bottom-to-top direction, a component of Al in AlGaN used for an upper buffer sub-layer 211 may be less than a component of Al in AlGaN used for a lower buffer sub-layer 211.

In another possible implementation, components of Al in first materials used for all the at least two buffer sub-layers 211 are the same or decrease progressively in the direction from the substrate 1 to the channel layer 23, so that a defect in the buffer sub-layer 211, such as dislocation, can be reduced.

In an implementation of the embodiments shown in FIG. 1 and FIG. 2, for example, components of Al in AlGaN (or InAlN, or the like) used for one of the at least two buffer sub-layers 211 may be the same, or may decrease progressively.

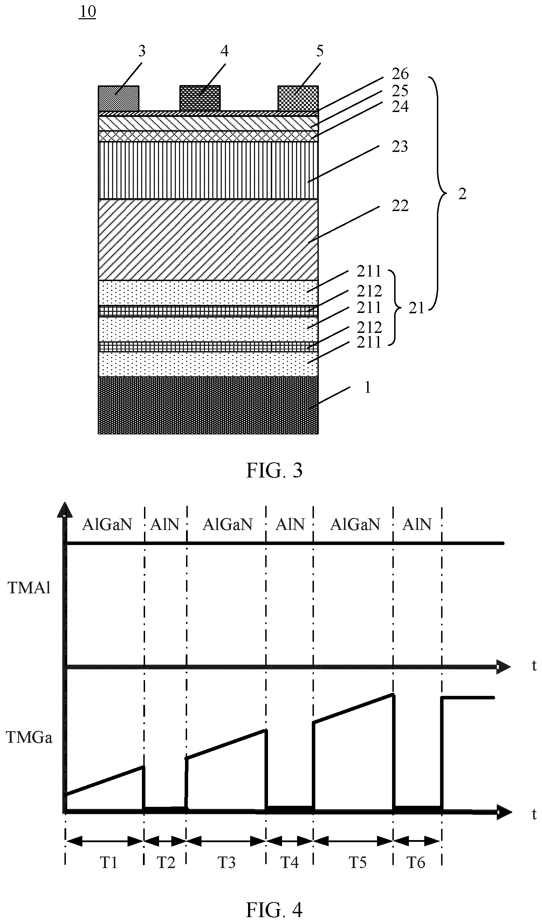

In an embodiment, as shown in FIG. 3, the buffer layer 21 may include three buffer sub-layers 211.

It may be understood that a buffer sub-layer 212 may be disposed in the stacked manner between a buffer sub-layer 211 close to the buffer layer 22 and a middle buffer sub-layer 211, and a buffer sub-layer 212 may also be disposed in the stacked manner between the middle buffer sub-layer 211 and a buffer sub-layer 211 close to the substrate 1.

In a possible implementation, a component (which may be represented by x) of Al in AlGaN used for the buffer sub-layer 211 close to the substrate 1 may be greater than 0.6 and less than or equal to 0.9, that is, 0.6<x≤0.9.

A component of Al in AlGaN used for the middle buffer sub-layer 211 may be greater than 0.3 and less than or equal to 0.6, that is, 0.3<x≤0.6.

A component of Al in AlGaN used for the buffer sub-layer 211 close to the buffer layer 22 is greater than or equal to 0.1 and less than or equal to 0.3, that is, 0.1<x≤0.3.

It can be learned from the foregoing embodiment that, components of Al in AlGaN respectively used for the three buffer sub-layers 211 may decrease progressively in the direction from the substrate 1 to the channel layer 23, so that the lattice mismatch between the buffer sub-layer 211 and the buffer sub-layer 212 can be reduced, and the lattice mismatch between the buffer layer 21 and the substrate 1 and the lattice mismatch between the buffer layer 21 and the buffer layer 22 can be further reduced.

It may be figured out that a sum of a component of Al in AlGaN and a component of gallium Ga (gallium) in AlGaN may be 1. For example, the component of Al in AlGaN is 0.25, the component of Ga in AlGaN is 0.75, and the sum of the two components may be 1.

In an example, AlGaN is used for the buffer sub-layer 211, and a material used for the buffer sub-layer 212 is AlN, so that the lattice mismatch between the buffer sub-layer 211 and the buffer sub-layer 212 can be reduced, and the defect in the buffer layer 21 can be further reduced.

It should be noted that FIG. 1 and FIG. 2 show only the field effect transistor 10 including two buffer sub-layers 211, and FIG. 3 shows the field effect transistor 10 including three buffer sub-layers 211. However, the field effect transistor 10 including more buffer sub-layers 211 may be implemented in the foregoing embodiment. The two layers in the examples in FIG. 1 and FIG. 2 may be two layers adjacent to a same buffer sub-layer 211 in a plurality of layers, or two layers adjacent to different buffer sub-layers 211 (for example, an uppermost layer and a lowermost layer). The three layers in the example in FIG. 3 may be three adjacent layers in a plurality of layers, or three nonadjacent layers (for example, another buffer sub-layer 212 is further disposed between every two layers).

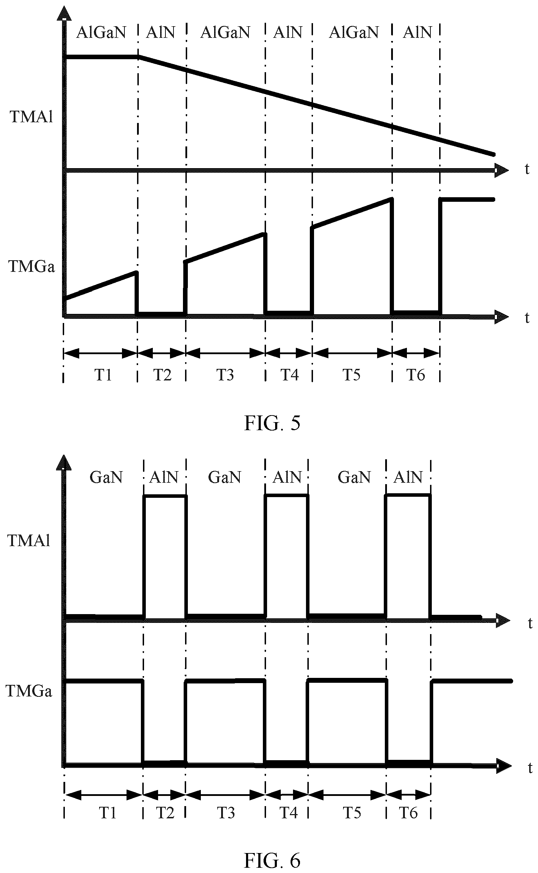

Further, a metal organic compound (metal organic, MO) growth gas source (which may be referred to as an MO gas source) used for the buffer sub-layer 211 and the buffer sub-layer 212 may include a trimethylaluminium (trimethylaluminium, TMAl) gas source (a TMAl gas source for short) and a trimethylgallium (trimethylgallium, TMGa) gas source (a TMGa gas source for short). A flow rate setting manner of the TMAl gas source and the TMGa gas source is shown in FIG. 4 and FIG. 5, where a horizontal coordinate t represents time, and a vertical coordinate represents a flow rate of the MO gas source. It should be noted that the MO gas source is not limited to the TMAl gas source and the TMGa gas source, and may alternatively be another metal organic compound gas source including Al and Ga. This is not limited in this embodiment of this application.

It can be learned from FIG. 4 that the buffer sub-layer 211 (that is, AlGaN in FIG. 4) and the buffer sub-layer 212 (that is, AlN in FIG. 4) may grow alternately.

It can also be learned from FIG. 4:
In a T1 time period, the buffer sub-layer 211 may grow. The TMAl gas source may maintain a fixed flow rate, and a flow rate of the TMGa gas source may gradually increase.

In a T2 time period, the buffer sub-layer 212 may grow. The TMAl gas source may continue to maintain the fixed flow rate, and the flow rate of the TMGa gas source may be 0 (that is, the TMGa gas source is disconnected).

In a T3 time period, the buffer sub-layer 211 may grow. The TMAl gas source may continue to maintain the fixed flow rate, and the flow rate of the TMGa gas source may gradually increase based on the T1 time period.

In a T4 time period, the buffer sub-layer 212 may grow. The TMAl gas source may continue to maintain the fixed flow rate, and the flow rate of the TMGa gas source may be 0.

In a T5 time period, the buffer sub-layer 211 may grow. The TMAl gas source may maintain the fixed flow rate, and the flow rate of the TMGa gas source may gradually increase based on the T3 time period.

In a T6 time period, the buffer sub-layer 212 may grow. The TMAl gas source may continue to maintain the fixed flow rate, and the flow rate of the TMGa gas source may be 0.

It can be learned from FIG. 5 that the buffer sub-layer 211 (that is, AlGaN in FIG. 5) and the buffer sub-layer 212 (that is, AlN in FIG. 5) may grow alternately.

It can also be learned from FIG. 5:

In a T1 time period, the buffer sub-layer 211 may grow. The TMAl gas source may maintain a fixed flow rate, and a flow rate of the TMGa gas source may gradually increase.

In a T2 time period, the buffer sub-layer 212 may grow. The flow rate of the TMAl gas source may gradually decrease based on the T1 time period, and the flow rate of the TMGa gas source may be 0.

In a T3 time period, the buffer sub-layer 211 may grow. The flow rate of the TMAl gas source may gradually decrease based on the T2 time period, and the flow rate of the TMGa gas source may gradually increase based on the T1 time period.

In a T4 time period, the buffer sub-layer 212 may grow. The flow rate of the TMAl gas source may gradually decrease based on the T3 time period, and the flow rate of the TMGa gas source may be 0.

In a T5 time period, the buffer sub-layer 211 may grow. The flow rate of the TMAl gas source may gradually decrease based on the T4 time period, and the flow rate of the TMGa gas source may gradually increase based on the T3 time period.

In a T6 time period, the buffer sub-layer 212 may grow. The flow rate of the TMAl gas source may gradually decrease based on the T5 time period, and the flow rate of the TMGa gas source may be 0.

It should be noted that FIG. 4 and FIG. 5 provide only three growth cycles of the buffer sub-layer 211 and the buffer sub-layer 212. Certainly, a growth cycle of the buffer sub-layer 211 and the buffer sub-layer 212 is not limited to the three growth cycles, and may be determined based on a requirement of an actual growth thickness and a quantity of layers.

It should be further noted that FIG. 4 and FIG. 5 provide only two possible flow rate setting manners of the TMAl gas source and the TMGa gas source. Certainly, the flow rate of the TMAl gas source and the flow rate of the TMGa gas source may be alternatively set in another manner. This is not limited in this embodiment of this application.

In another example, a component of Al in AlGaN used for the buffer sub-layer 211 may be 0. In other words, a material used for the buffer sub-layer 211 is GaN.

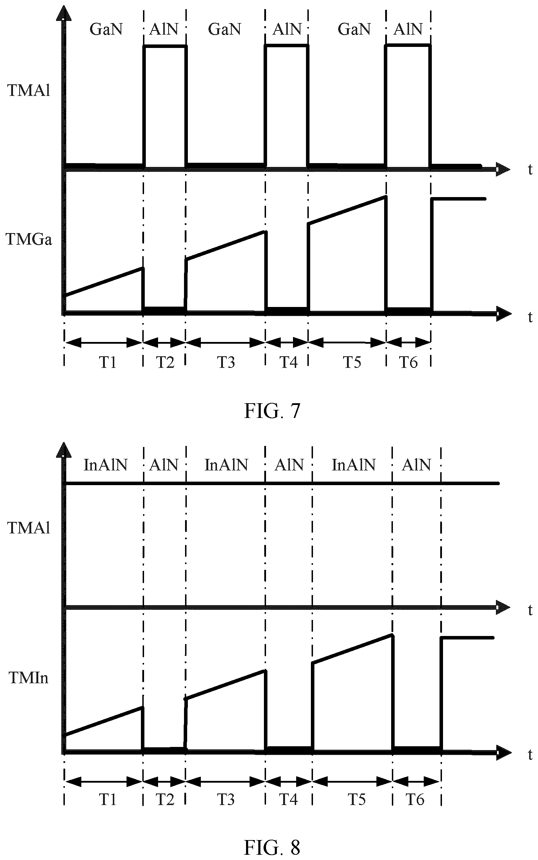

In this case, the MO gas source used for the buffer sub-layer 211 and the buffer sub-layer 212 may also include the TMAl gas source and the TMGa gas source. A flow rate setting manner of the TMAl gas source and the TMGa gas source is shown in FIG. 6 and FIG. 7, where a horizontal coordinate t represents time, and a vertical coordinate represents a flow rate of the MO gas source. It should be noted that the MO gas source is not limited to the TMAl gas source and the TMGa gas source, and may alternatively be another metal organic compound gas source including Al and Ga. This is not limited in this embodiment of this application.

It can be learned from FIG. 6 that the buffer sub-layer 211 (that is, GaN in FIG. 6) and the buffer sub-layer 212 (that is, AlN in FIG. 6) may grow alternately.

It can also be learned from FIG. 6:
In a T1 time period, a T3 time period, and a T5 time period, the buffer sub-layer 211 may separately grow. A flow rate of the TMAl gas source may be 0, and a flow rate of the TMGa gas source may maintain a fixed flow rate.

In a T2 time period, a T4 time period, and a T6 time period, the buffer sub-layer 212 may separately grow. The TMAl gas source may maintain a fixed flow rate, and the flow rate of the TMGa gas source may be 0.

It can be learned from FIG. 7:
In a T1 time period, the buffer sub-layer 211 may grow. A flow rate of the TMAl gas source may be 0, and a flow rate of the TMGa gas source may gradually increase.

In a T3 time period, the buffer sub-layer 211 may grow. The flow rate of the TMAl gas source may be 0, and the flow rate of the TMGa gas source may gradually increase based on the T1 time period.

In a T5 time period, the buffer sub-layer 211 may grow. The flow rate of the TMAl gas source may be 0, and the flow rate of the TMGa gas source may gradually increase based on the T3 time period.

In a T2 time period, a T4 time period, and a T6 time period, the buffer sub-layer 212 may grow. The TMAl gas source may maintain a fixed flow rate, and the flow rate of the TMGa gas source may be 0.

It should be noted that FIG. 6 and FIG. 7 provide only three growth cycles of the buffer sub-layer 211 and the buffer sub-layer 212. Certainly, a growth cycle of the buffer sub-layer 211 and the buffer sub-layer 212 is not limited to the three growth cycles, and may be determined based on a requirement of an actual growth thickness and a quantity of layers.

It should be further noted that FIG. 6 and FIG. 7 provide only two possible flow rate setting manners of the TMAl gas source and the TMGa gas source. Certainly, the flow rate of the TMAl gas source and the flow rate of the TMGa gas source may be alternatively set in another manner. This is not limited in this embodiment of this application.

In another possible implementation, a component of Al in InAlN used for the buffer sub-layer 211 close to the substrate 1 is greater than 0.941 and less than or equal to 1, that is, 0.941<x≤1.

A component of Al in InAlN used for the middle buffer sub-layer 211 is greater than 0.883 and less than or equal to 0.941, that is, 0.883<x≤0.941.

A component of Al in InAlN used for the buffer sub-layer 211 close to the buffer layer 22 is greater than or equal to 0.825 and less than or equal to 0.883, that is, 0.825<x≤0.883.

It can be learned from the foregoing embodiment that, components of Al in InAlN respectively used for the three buffer sub-layers 211 may decrease progressively in the direction from the substrate 1 to the channel layer 23, so that the lattice mismatch between the buffer sub-layer 211 and the buffer sub-layer 212 can be reduced, and the lattice mismatch between the buffer layer 21 and the substrate 1 and the lattice mismatch between the buffer layer 21 and the buffer layer 22 can be further reduced.

It may be figured out that a sum of a component of Al in InAlN and a component of indium In (indium) in InAlN may be 1. For example, the component of Al in InAlN is 0.85, the component of In in InAlN is 0.15, and the sum of the two components is 1.

In an example, InAlN is used for the buffer sub-layer 211, and a material used for the buffer sub-layer 212 is AlN.

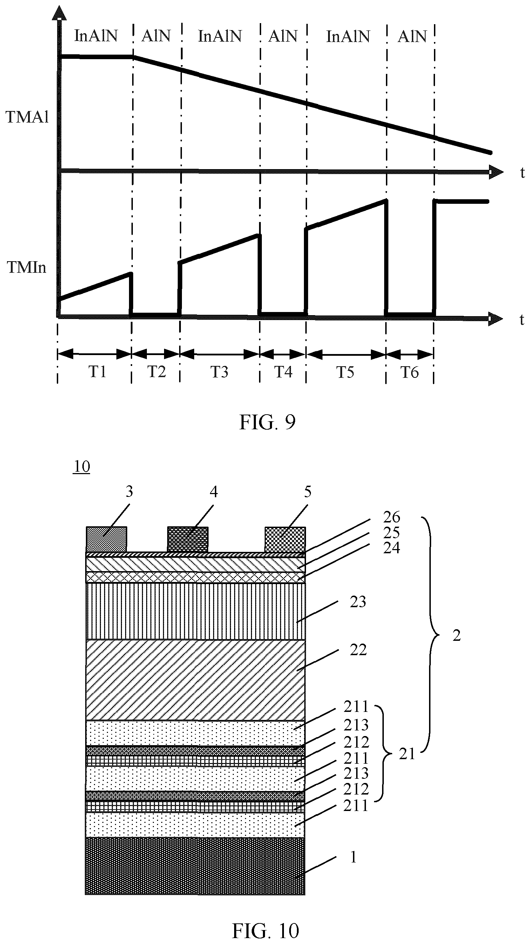

In this case, the MO gas source used for the buffer sub-layer 211 and the buffer sub-layer 212 may include a TMAl gas source and a trimethylindium (trimethylindium, TMIn) gas source (a TMIn gas source for short). A flow rate setting manner of the TMAl gas source and the TMIn gas source is shown in FIG. 8 and FIG. 9, where a horizontal coordinate t represents time, and a vertical coordinate represents a flow rate of the MO gas source. It should be noted that the MO gas source is not limited to the TMAl gas source and the TMIn gas source, and may alternatively be another metal organic compound gas source including Al and In. This is not limited in this embodiment of this application.

It can be learned from FIG. 8 that the buffer sub-layer 211 (that is, InAlN in FIG. 8) and the buffer sub-layer 212 (that is, AlN in FIG. 8) may grow alternately.

It can also be learned from FIG. 8:

In a T1 time period, the buffer sub-layer 211 may grow. The TMAl gas source may maintain a fixed flow rate, and a flow rate of the TMIn gas source may gradually increase.

In a T2 time period, the buffer sub-layer 212 may grow. The TMAl gas source may continue to maintain the fixed flow rate, and the flow rate of the TMIn gas source may be 0 (that is, the TMGa gas source is disconnected).

In a T3 time period, the buffer sub-layer 211 may grow. The TMAl gas source may continue to maintain the fixed flow rate, and the flow rate of the TMIn gas source may gradually increase based on the T1 time period.

In a T4 time period, the buffer sub-layer 212 may grow. The TMAl gas source may continue to maintain the fixed flow rate, and the flow rate of the TMIn gas source may be 0.

In a T5 time period, the buffer sub-layer 211 may grow. The TMAl gas source may maintain the fixed flow rate, and the flow rate of the TMIn gas source may gradually increase based on the T3 time period.

In a T6 time period, the buffer sub-layer 212 may grow. The TMAl gas source may continue to maintain the fixed flow rate, and the flow rate of the TMIn gas source may be 0.

It can be learned from FIG. 9 that the buffer sub-layer 211 (that is, InAlN in FIG. 9) and the buffer sub-layer 212 (that is, AlN in FIG. 9) may grow alternately.

It can also be learned from FIG. 9:
In a T1 time period, the buffer sub-layer 211 may grow. The TMAl gas source may maintain a fixed flow rate, and a flow rate of the TMIn gas source may gradually increase.

In a T2 time period, the buffer sub-layer 212 may grow. The flow rate of the TMAl gas source may gradually decrease based on the T1 time period, and the flow rate of the TMIn gas source may be 0.

In a T3 time period, the buffer sub-layer 211 may grow. The flow rate of the TMAl gas source may gradually decrease based on the T2 time period, and the flow rate of the TMIn gas source may gradually increase based on the T1 time period.

In a T4 time period, the buffer sub-layer 212 may grow. The flow rate of the TMAl gas source may gradually decrease based on the T3 time period, and the flow rate of the TMIn gas source may be 0.

In a T5 time period, the buffer sub-layer 211 may grow. The flow rate of the TMAl gas source may gradually decrease based on the T4 time period, and the flow rate of the TMIn gas source may gradually increase based on the T3 time period.

In a T6 time period, the buffer sub-layer 212 may grow. The flow rate of the TMAl gas source may gradually decrease based on the T5 time period, and the flow rate of the TMIn gas source may be 0.

It should be noted that FIG. 8 and FIG. 9 provide only three growth cycles of the buffer sub-layer 211 and the buffer sub-layer 212. Certainly, a growth cycle of the buffer sub-layer 211 and the buffer sub-layer 212 is not limited to the three growth cycles, and may be determined based on a requirement of an actual growth thickness and a quantity of layers.

It should be further noted that FIG. 8 and FIG. 9 provide only two possible flow rate setting manners of the TMAl gas source and the TMIn gas source. Certainly, the flow rate of the TMAl gas source and the flow rate of the TMIn gas source may be alternatively set in another manner. This is not limited in this embodiment of this application.

In some embodiments, based on FIG. 2, a buffer sub-layer 213 (that is, a third buffer sub-layer) may be further disposed in the stacked manner between the at least two buffer sub-layers 211, as shown in FIG. 10.

A third material is used for each of the buffer sub-layer 213 and the channel layer 23. In an embodiment, the third material is used for each of the buffer sub-layer 213, the buffer layer 212, and the channel layer 23. For example, GaN is used for each of the buffer sub-layer 213, the buffer sub-layer 212, and the channel layer 23.

Further, elements included in the third material may be not totally the same as the elements included in the first material and the elements included in the second material. In other words, the elements included in the third material may be partially different from or may be totally different from the elements included in the first material and the elements included in the second material.

In an implementation shown in FIG. 10, the third material used for the buffer sub-layer 213 is gallium nitride GaN, and a thickness of the buffer sub-layer 213 may range from 5 nm to 300 nm, so that lattice mismatch between the buffer sub-layer 212 and the buffer sub-layer 213 can be reduced. Certainly, another material may alternatively be used for the buffer sub-layer 213, and the buffer sub-layer 213 may alternatively be in another thickness range. This is not limited in this embodiment of this application.

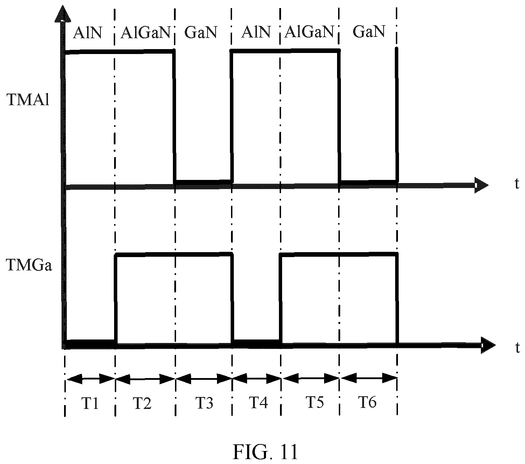

Further, an MO gas source used for the buffer sub-layer 211, the buffer sub-layer 212, and the buffer sub-layer 213 may include a TMAl gas source and a TMGa gas source. A flow rate setting manner of the TMAl gas source and the TMGa gas source is shown in FIG. 11, where a horizontal coordinate t represents time, and a vertical coordinate represents a flow rate of the MO gas source. It should be noted that the MO gas source is not limited to the TMAl gas source and the TMGa gas source, and may alternatively be another metal organic compound gas source including Al and Ga. This is not limited in this embodiment of this application.

It can be learned from FIG. 11 that the buffer sub-layer 211 (that is, AlGaN in FIG. 11), the buffer sub-layer 213 (that is, GaN in FIG. 11), and the buffer sub-layer 212 (that is, AlN in FIG. 11) may grow sequentially.

It can also be learned from FIG. 11:
In a T1 time period and a T4 time period, the buffer sub-layer 212 may grow. The TMAl gas source may maintain a fixed flow rate, and the flow rate of the TMGa gas source may be 0.

In a T2 time period and a T5 time period, the buffer sub-layer 211 may grow. The TMAl gas source and the TMGa gas source each may maintain a fixed flow rate.

In a T3 time period and a T6 time period, the buffer sub-layer 213 may grow. The flow rate of the TMAl gas source may be 0, and the flow rate of the TMGa gas source may maintain the fixed flow rate.

It should be noted that FIG. 11 provides only two growth cycles of the buffer sub-layer 211, the buffer sub-layer 213, and the buffer sub-layer 212. Certainly, a growth cycle of the buffer sub-layer 211, the buffer sub-layer 213, and the buffer sub-layer 212 is not limited to two growth cycles, and may be determined based on a requirement of an actual growth thickness and a quantity of layers.

It should be further noted that FIG. 11 provides only one possible flow rate setting manner of the TMAl gas source and the TMGa gas source. Certainly, the flow rate of the TMAl gas source and the flow rate of the TMGa gas source may be alternatively set in another manner. This is not limited in this embodiment of this application.

In another example, InAlN is used for the buffer sub-layer 211, a material used for the buffer sub-layer 212 is AlN, and GaN is used for the buffer sub-layer 213.

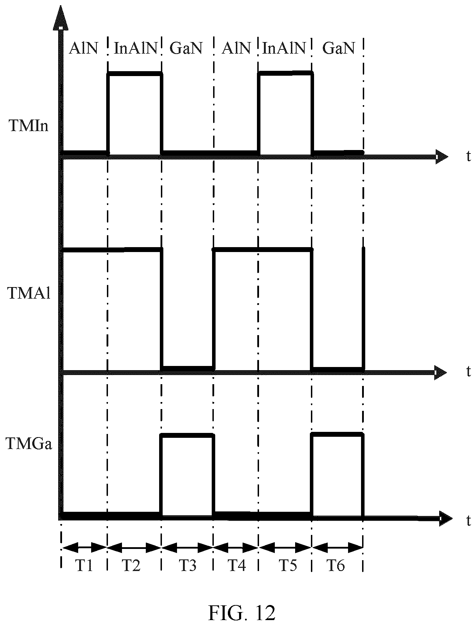

In this case, an MO gas source used for the buffer sub-layer 211, the buffer sub-layer 212, and the buffer sub-layer 213 may include a TMAl gas source, a TMGa gas source, and a TMIn gas source. A flow rate setting manner of the TMAl gas source, the TMGa gas source, and the TMIn gas source is shown in FIG. 12, where a horizontal coordinate t represents time. It should be noted that the MO gas source is not limited to the TMAl gas source, the TMGa gas source, and the TMIn gas source, and may alternatively be another metal organic compound gas source including Al, Ga, and In. This is not limited in this embodiment of this application.

It can be learned from FIG. 12 that the buffer sub-layer 211 (that is, InAlN in FIG. 12), the buffer sub-layer 213 (that is, GaN in FIG. 12), and the buffer sub-layer 212 (that is, AlN in FIG. 11) may grow sequentially.

It can also be learned from FIG. 12:
In a T1 time period and a T4 time period, the buffer sub-layer 212 may grow. The TMAl gas source may maintain a fixed flow rate, and flow rates of the TMGa gas source and the TMIn gas source each may be 0.

In a T2 time period and a T5 time period, the buffer sub-layer 211 may grow. The TMAl gas source and the TMIn gas source may maintain a fixed flow rate, and the flow rate of the TMGa gas source may be 0.

In a T3 time period and a T6 time period, the buffer sub-layer 213 may grow. The flow rates of the TMAl gas source and the TMIn gas source each may be 0, and the TMGa gas source may maintain a fixed flow rate.

It should be noted that FIG. 12 provides only two growth cycles of the buffer sub-layer 211, the buffer sub-layer 213, and the buffer sub-layer 212. Certainly, a growth cycle of the buffer sub-layer 211, the buffer sub-layer 213, and the buffer sub-layer 212 is not limited to two growth cycles, and may be determined based on a requirement of an actual growth thickness and a quantity of layers.

It should be further noted that FIG. 12 provides only one possible flow rate setting manner of the TMAl gas source, the TMGa gas source, and the TMIn gas source. Certainly, the flow rates of the TMAl gas source, the TMGa gas source, and the TMIn gas source may be alternatively set in another manner. This is not limited in this embodiment of this application.

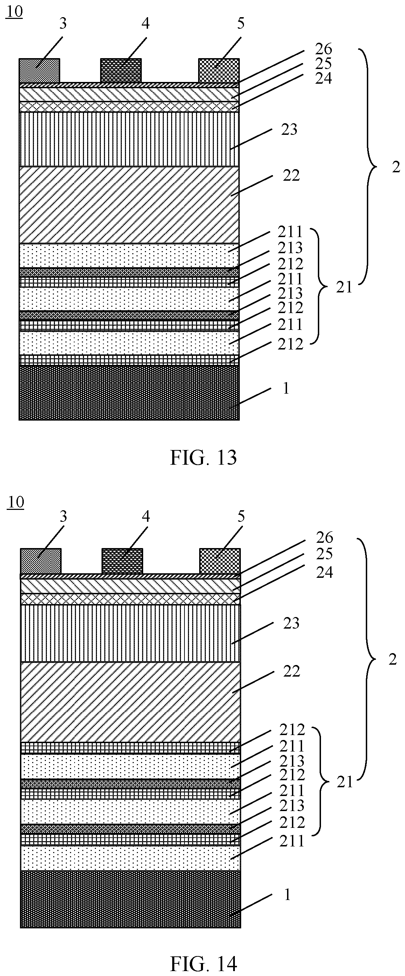

In a possible implementation, based on FIG. 10, as shown in FIG. 13, the buffer sub-layer 212 may be disposed in the stacked manner between the buffer sub-layer 211 close to the substrate 1 in the at least two buffer sub-layers 211 (that is, the three layers in FIG. 10) and the substrate 1, so that the lattice mismatch between the substrate 1 and the buffer sub-layer 211, and the defect in the buffer layer 21, such as the dislocation, can be further reduced.

In another possible implementation, based on FIG. 10, as shown in FIG. 14, the buffer sub-layer 212 may be disposed in the stacked manner between the buffer sub-layer 211 close to the buffer layer 22 in the at least two buffer sub-layers 211 (that is, the three layers in FIG. 13) and the buffer layer 22, so that the lattice mismatch between the buffer layer 22 and the buffer sub-layer 211, and the defect in the buffer layer 21, such as the dislocation, can be further reduced.

It can be learned from FIG. 13 and FIG. 14 that a thickness of the buffer sub-layer 212 may be less than or equal to a thickness of each of the at least two buffer sub-layers 211, so that lattice mismatch between the buffer sub-layer 212 and the buffer sub-layer 213 can be reduced, and the defect in the buffer layer 21, such as the dislocation, can be further reduced.

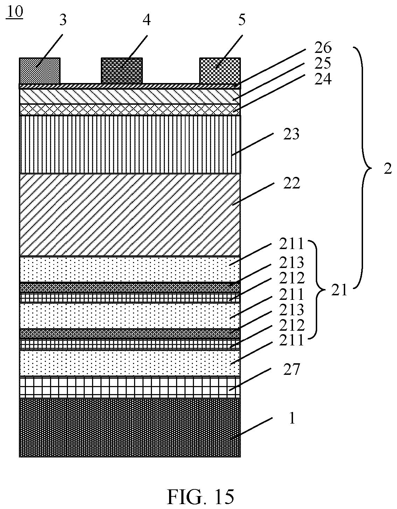

In a possible implementation, the epitaxial layer 2 may further include a nucleation layer 27, and the nucleation layer 27 may be disposed in the stacked manner between the substrate 1 and the buffer layer 211, as shown in FIG. 15.

For example, the second material may be used for the nucleation layer 27. In other words, AlN may be used for the nucleation layer 27. Certainly, another material may alternatively be used for the nucleation layer 27. This is not limited in this embodiment of this application.

Further, a thickness of the nucleation layer 27 may range from 100 nm to 400 nm. Certainly, the nucleation layer 27 may alternatively be in another thickness range. This is not limited in this embodiment of this application.

The nucleation layer 27 is configured to provide a same nucleation center as the substrate 1, release mismatch stress generated by the lattice mismatch between the substrate 1 and the buffer layer 21 and thermal stress generated by thermal expansion coefficient mismatch between the substrate 1 and the buffer layer 21, and provide a flatter surface for further growth of the buffer layer 21.

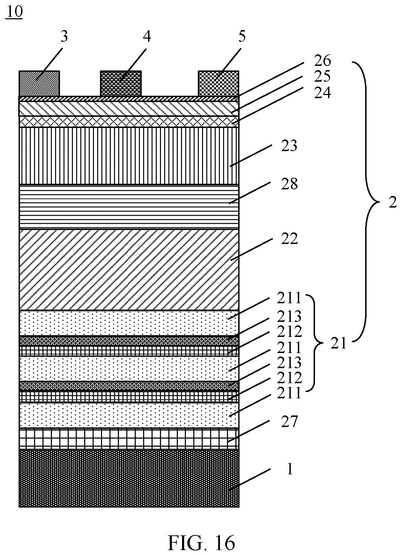

In another possible implementation, a buffer layer 28 may be further disposed in the stacked manner between the buffer layer 22 and the channel layer 23, as shown in FIG. 16.

For example, the first material is used for the buffer layer 28. In other words, AlGaN may be used for the buffer layer 28. Certainly, another material may alternatively be used for the buffer layer 28. This is not limited in this embodiment of this application.

Further, a thickness of the buffer layer 28 may range from 10 nm to 1000 nm. Certainly, the buffer layer 28 may alternatively be in another thickness range. This is not limited in this embodiment of this application.

The buffer layer 28 may be configured to isolate the channel layer 23 from the buffer layer 22, to improve confinement of two-dimensional electron gas. The channel layer 23 and the buffer layer 28 form a heterojunction to provide a flow channel for the two-dimensional electron gas.

An embodiment of this application further provides an electronic chip, where the electronic chip may include a passive device (such as a resistor or a capacitor) and a field effect transistor 10 that is electrically connected to the passive device.

An embodiment of this application further provides an electronic device, where the electronic device may include a circuit board and an electronic chip disposed on the circuit board.

The foregoing descriptions are merely specific implementations of this application, but are not intended to limit the protection scope of this application. Any variation or replacement readily figured out by a person skilled in the art within the technical scope disclosed in this application shall fall within the protection scope of this application. Therefore, the protection scope of this application shall be subject to the protection scope of the claims.

## Claims

1. A semiconductor component, comprising a substrate, a first buffer layer, a second buffer layer, and a channel layer that are disposed in a stacked manner, wherein
the first buffer layer comprises at least two first buffer sub-layers that are disposed in the stacked manner, and a second buffer sub-layer is disposed in the stacked manner between the at least two first buffer sub-layers; and
a first material is used for each of the at least two first buffer sub-layers, a second material is used for the second buffer sub-layer, and elements comprised in the first material are not totally the same as elements comprised in the second material.

2. The semiconductor component according to claim 1, wherein thicknesses of the at least two first buffer sub-layers are the same.

3. The semiconductor component according to claim 1, wherein thicknesses of the at least two first buffer sub-layers increase or decrease progressively in a direction from the substrate to the channel layer.

4. The semiconductor component according to claim 2 or 3, wherein the first material is aluminum gallium nitride AlGaN or indium aluminum nitride InAlN, and the second material is aluminum nitride AlN.

5. The semiconductor component according to claim 4, wherein components of aluminum Al in first materials respectively used for the at least two first buffer sub-layers decrease progressively in the direction from the substrate to the channel layer.

6. The semiconductor component according to claim 4 or 5, wherein components of aluminum Al in first materials used for all the at least two first buffer sub-layers are the same or decrease progressively in the direction from the substrate to the channel layer.

7. The semiconductor component according to claim 5 or 6, wherein the first buffer layer comprises three first buffer sub-layers;
a component of Al in AlGaN used for a first buffer sub-layer close to the substrate is greater than 0.6 and less than or equal to 0.9;
a component of Al in AlGaN used for a first buffer sub-layer close to the second buffer layer is greater than or equal to 0.1 and less than or equal to 0.3; and
a component of Al in AlGaN used for a first buffer sub-layer between the first buffer sub-layer close to the substrate and the first buffer sub-layer close to the second buffer layer is greater than 0.3 and less than or equal to 0.6.

8. The semiconductor component according to claim 5 or 6, wherein the first buffer layer comprises three first buffer sub-layers;
a component of Al in InAlN used for a first buffer sub-layer close to the substrate is greater than 0.941 and less than or equal to 1;
a component of Al in InAlN used for a first buffer sub-layer close to the second buffer layer is greater than or equal to 0.825 and less than or equal to 0.883; and
a component of Al in InAlN used for a first buffer sub-layer between the first buffer sub-layer close to the substrate and the first buffer sub-layer close to the second buffer layer is greater than 0.883 and less than or equal to 0.941.

9. The semiconductor component according to any one of claims 1 to 8, wherein a third buffer sub-layer is further disposed in the stacked manner between the at least two first buffer sub-layers;
a third material is used for each of the third buffer sub-layer and the channel layer; and
elements comprised in the third material are not totally the same as the elements comprised in the first material and the elements comprised in the second material.

10. The semiconductor component according to claim 9, wherein the third material is gallium nitride GaN.

11. The semiconductor component according to claim 9 or 10, wherein a thickness of the third buffer sub-layer ranges from 5 nm to 300 nm.

12. The semiconductor component according to any one of claims 1 to 11, wherein a second buffer sub-layer is disposed in the stacked manner between the first buffer sub-layer close to the substrate in the at least two first buffer sub-layers and the substrate; and
a second buffer sub-layer is disposed in the stacked manner between the first buffer sub-layer close to the second buffer layer in the at least two first buffer sub-layers and the second buffer layer.

13. The semiconductor component according to any one of claims 1 to 12, wherein a thickness of the second buffer sub-layer is less than or equal to a thickness of each of the at least two first buffer sub-layers.

14. The semiconductor component according to claim 13, wherein the thickness of each first buffer sub-layer ranges from 5 nm to 300 nm;
the thickness of the second buffer sub-layer ranges from 5 nm to 50 nm;
a thickness of the first buffer layer is less than or equal to 1200 nm;
a thickness of the second buffer layer ranges from 500 nm to 2000 nm; and
a thickness of the channel layer ranges from 50 nm to 1000 nm.

15. The semiconductor component according to any one of claims 1 to 14, wherein the semiconductor component further comprises a nucleation layer, and the nucleation layer is disposed in the stacked manner between the substrate and the first buffer layer.

16. The semiconductor component according to claim 15, wherein the second material is used for the nucleation layer; and
a thickness of the nucleation layer ranges from 100 nm to 400 nm.

17. The semiconductor component according to any one of claims 1 to 16, wherein a third buffer layer is further disposed in the stacked manner between the second buffer layer and the channel layer;
the first material is used for the third buffer layer; and
a thickness of the third buffer layer ranges from 10 nm to 1000 nm.

18. An electronic chip, comprising a passive device and the semiconductor component according to any one of claims 1 to 17 that is electrically connected to the passive device.

19. An electronic device, comprising a circuit board and the electronic chip according to claim 18 disposed on the circuit board.
